# EUROPEAN PATENT APPLICATION

(11) **EP 4 739 011 A1**
(43) Date of publication of application: **06.05.2026**
(21) Application number: 24886135.3
(22) Date of filing: 24.10.2024
(51) Int. Cl.: H05K 5/06, H05K 5/00, H04M 1/02

(54) **ELECTRONIC DEVICE INCLUDING WATERPROOF STRUCTURE**

(30) Priority: 03.11.2023 KR 20230151059; 11.12.2023 KR 20230178991
(71) Applicant: Samsung Electronics Co., Ltd., Suwon-si, Gyeonggi-do 16677 (KR)
(72) Inventor: CHANG, Borami, Suwon-si Gyeonggi-do 16677 (KR); KIM, Donghak, Suwon-si Gyeonggi-do 16677 (KR); LIM, Heekwang, Suwon-si Gyeonggi-do 16677 (KR); LIM, Hyosang, Suwon-si Gyeonggi-do 16677 (KR)
(74) Representative: Appleyard Lees IP LLP
(86) International application number: PCT/KR2024/016272
(87) International publication number: WO 2025/095460

(57) **Abstract**

An electronic device includes a front plate and a back plate. The electronic device includes a front case including a first face facing the front plate, a second face facing the back plate, and a first side face oriented in a lateral direction, where the front case is arranged between the front plate and the back plate. The electronic device includes a rear case including a third face facing the front plate, a fourth face facing the back plate, and a second side face oriented in the lateral direction, where the rear case is arranged between the front case and the back plate and is coupled to the front case. The electronic device includes a waterproof structure including a first waterproof member disposed on the front case and a second waterproof member disposed on the rear case.

## Description

### [Technical Field]

Embodiments of the disclosure relate to a waterproof structure for an electronic device.

### [Background Art]

A housing of an electronic device can have a waterproof structure arranged between a front case and a rear case in order to prevent or reduce moisture penetration into the housing. The waterproof structure can be arranged in a closed-curve shape along a corner region of the housing.

When the front case is coupled to the rear case, the waterproof structure arranged between the front case and the rear case is arranged in a compressed state and may prevent or reduce moisture penetration into the housing.

The waterproof structure is formed of an elastic material and has a structure capable of previously preventing or reducing the penetration of moisture introduced into a side face of the housing.

### [Disclosure of Invention]

### [Solution to Problem]

However, since a waterproof structure arranged in a housing for waterproofing an electronic device arranges a waterproof member of a closed-curve shape between a front case and a rear case, moisture introduced into a gap formed in a side face of the housing can penetrate via an inner side face of the housing.

Accordingly, for example, moisture penetration through a side key, a power key, or a hole formed in the side face of the housing may not be completely prevented.

In some aspects, the integrated waterproof member of the closed-curve shape may be uneconomical in that many portions are wasted during manufacturing.

In some aspects, since a large area of the integrated waterproof member of the closed-curve shape is arranged in the housing, it may be difficult to repair the integrated waterproof member.

According to an embodiment of the disclosure, there is provided an electronic device in which a waterproof structure is arranged at an entry point of moisture penetration, thereby achieving complete waterproofing.

According to an embodiment of the disclosure, there is provided an electronic device having a structure in which a waterproof member is disposed on a front case and a rear case, thereby reducing wasted portions of a waterproof fabric when the waterproof member is manufactured.

According to an embodiment of the disclosure, there is provided an electronic device in which repair is easy in that a waterproof member is divided and disposed on a front case and a rear case.

A technical task to be achieved in this document is not limited to the technical task described herein, and other technical tasks not mentioned can be clearly understood by those skilled in the art from the descriptions herein.

As a technical means for achieving the technical tasks described herein, one aspect of the disclosure provides an electronic device including a front plate, a back plate, a front case including a first face facing the front plate, a second face facing the back plate, and a first side face oriented in a lateral direction, where the front case is arranged between the front plate and the back plate, a rear case including a third face facing the front plate, a fourth face facing the back plate, and a second side face oriented in the lateral direction, where the rear case is arranged between the front case and the back plate and is coupled to the front case, and a waterproof structure including a first waterproof member disposed on the front case, and a second waterproof member disposed on the rear case. A portion of the first waterproof member is connected to a portion of the second waterproof member, and a boundary portion where the first waterproof member is connected to the second waterproof member includes an overlapping portion.

Another aspect of the disclosure provides an electronic device including a front case including a first face, a second face opposite the first face, and a first side face surrounding at least a portion between the first face and the second face, a rear case including a third face facing the second face, a fourth face opposite the third face, and a second side face surrounding at least a portion of the rear case between the third face and the fourth face, where the rear case is coupled to the front case; and a waterproof structure including a first waterproof member disposed on the first side face, and a second waterproof member disposed on the third face. A portion of the first waterproof member is connected to a portion of the second waterproof member, and a boundary portion where the first waterproof member is connected to the second waterproof member includes an overlapping portion.

According to an embodiment of the disclosure, aspects of a waterproof structure described herein may prevent or reduce moisture penetration through a side key, a power key, or a hole into an electronic device. In some aspects, according to an embodiment of the disclosure, the waterproof member is arranged in a divided state, which is economical and supports a reduction in wasted portions when the waterproof member is manufactured and reduced complexity associated with repair of the waterproof member.

In some aspects, according to an embodiment of the disclosure, a waterproof structure may be arranged at an entry point of moisture penetration, thereby achieving complete waterproofing.

Effects obtainable from the disclosure are not limited to the effects described herein, and other effects not mentioned can be clearly understood by those skilled in the art from the descriptions herein.

### [Brief Description of Drawings]

FIG. 1 is a perspective view illustrating the front of an electronic device according to an embodiment.
FIG. 2 is a perspective view illustrating the rear of an electronic device according to an embodiment.
FIG. 3 is an exploded perspective view schematically illustrating an internal structure of an electronic device according to an embodiment.
FIG. 4 is a plan view illustrating a front case, a rear case, and a waterproof structure that constitute an electronic device, according to an embodiment.
FIG. 5 is a plan view illustrating a waterproof structure arranged in each of a front case and a rear case that constitute an electronic device, according to an embodiment.
FIG. 6 is an example diagram illustrating a waterproof structure of an electronic device according to an embodiment.
FIG. 7 is a plan view and a side view illustrating a front case according to an embodiment.
FIG. 8 is an enlarged view illustrating region A of FIG. 7.
FIG. 9 is a perspective view illustrating region A of FIG. 7.
FIG. 10 is a front view illustrating a protrusion portion of one end of a first waterproof member according to an embodiment.
FIG. 11 is a plan view illustrating a rear case in which a second waterproof member is arranged, according to an embodiment.
FIG. 12 is an enlarged view illustrating region B of FIG. 11.
FIG. 13 is a perspective view illustrating region B of FIG. 11.
FIG. 14 is a perspective view illustrating a state in which a first waterproof member and a second waterproof member are overlapped and arranged, according to an embodiment.
FIG. 15 is a front view illustrating a state in which a first waterproof member and a second waterproof member are overlapped and arranged, according to an embodiment.
FIG. 16 is a perspective view illustrating a state in which a first waterproof member and a second waterproof member are overlapped and arranged, according to an embodiment.
FIG. 17 is a plan view illustrating a state in which a first waterproof member and a second waterproof member are overlapped and arranged, according to an embodiment.
FIG. 18 is a cross-sectional view sequentially illustrating a process in which a rear case is coupled in a state where a first waterproof member is attached to a front case, according to an embodiment.
FIG. 19 is a cross-sectional view illustrating a waterproof structure in a straight section, according to an embodiment.
FIG. 20 is a cross-sectional view illustrating a waterproofing structure in an overlapping section, according to an embodiment.
FIG. 21 is a cross-sectional view illustrating a waterproof structure in a curve section, according to an embodiment.
FIG. 22 is a cross-sectional view illustrating the arrangement of a first waterproof member, according to an embodiment.
FIG. 23A is a cross-sectional view illustrating a waterproof structure in an overlapping section, according to an embodiment, FIG. 23B illustrates the amount of overlap when an attachment surface of a front case is 3 degrees, and FIG. 23C is an example diagram illustrating the amount of overlap when the attachment surface of the front case is 5 degrees.
FIG. 24A is a cross-sectional view illustrating a waterproofing structure in an overlapping section, according to an embodiment, and FIG. 24B is a diagram illustrating a protrusion portion of a first waterproof member overlapping .
FIG. 25A is a cross-sectional view illustrating a state in which the amount of overlap between a first waterproof member and a second waterproof member is insufficient, according to an embodiment, and FIG. 25B is a perspective view illustrating a moisture penetration path with arrows.
FIG. 26A is a cross-sectional view illustrating a state in which a first waterproof member and a second waterproof member have an appropriate amount of overlap, according to an embodiment, and FIG. 26B is a perspective view illustrating a moisture penetration path with arrows.
FIG. 27A is a cross-sectional view illustrating a state in which the amount of overlap between a first waterproof member and a second waterproof member is excessive, according to an embodiment, and FIG. 27B is a perspective view illustrating a moisture penetration path with arrows.

In relation to the description of the drawings, the same or similar reference numerals may be used for the same or similar components.

### [Mode for Carrying out the Invention]

Embodiments of the disclosure are described herein in detail with reference to the attached drawings such that the embodiments may be easily implemented by those skilled in the art to which the disclosure pertains. However, the disclosure may be implemented in many different forms and is not limited to the embodiments described herein. In order to clearly explain the disclosure in the drawings, parts not related to the description are omitted, and similar parts are given similar reference numerals throughout the specification.

The terms used in the disclosure are described as currently used general terms in consideration of functions mentioned in the disclosure, but they may mean various other terms depending on the intention or precedents of those skilled in the art, the emergence of new technologies, etc. Accordingly, the terms used in the disclosure should not be interpreted only by their names, but should be interpreted based on the meaning of the terms and the overall content of the disclosure.

In some aspects, terms such as, for example, first, second, etc. may be used to describe various components, but the components should not be limited by these terms. These terms are used for the purpose of distinguishing one component from another component.

Throughout the specification, when a part is said to be "connected" to another part, this includes not only that it is "directly connected," but also that it is "physically in contact." In some aspects, when a part "includes" a certain component, this means that it may further include other components rather than excluding other components, unless specifically stated to the contrary.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

Phrases such as "in an embodiment" appearing in various places in the disclosure do not necessarily all refer to the same embodiment.

An embodiment of the disclosure may be represented by functional block constructions and various processing steps. Some or all of these functional blocks may be implemented as various numbers of hardware and/or software constructions that perform specific functions. For example, the functional blocks of the disclosure may be implemented by one or more microprocessors or be implemented by circuit constructions for certain functions. In some aspects, for example, the functional blocks of the disclosure may be implemented in various programming or scripting languages. The functional blocks may be implemented as algorithms executed in one or more processors. In some aspects, the disclosure may employ conventional technologies for electronic environment setup, signal processing, and/or data processing, etc. Terms such as, for example, "mechanism," "element," "means," and "construction" may be used broadly and are not limited to mechanical and physical components.

In some aspects, connection lines or connection members between components illustrated in the drawings merely exemplify functional connections and/or physical or circuit connections. In an actual device, connections between components may be represented by various replaceable or additional functional connections, physical connections, or circuit connections.

The disclosure is described herein in detail with reference to the attached drawings.

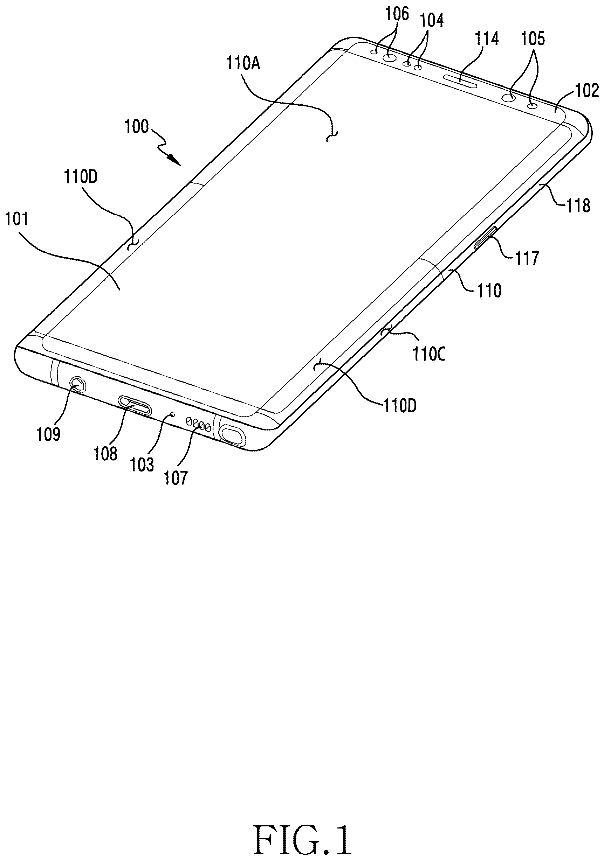

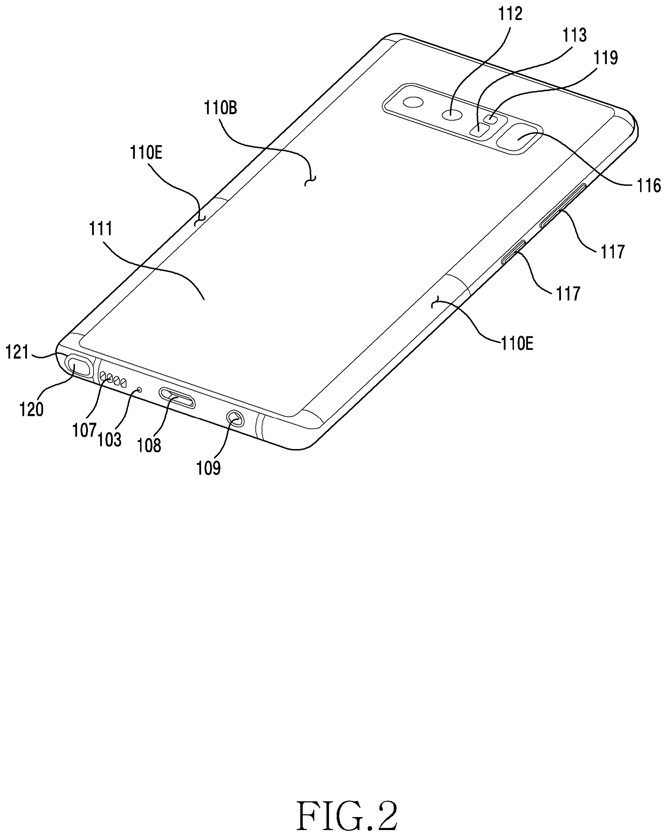

FIG. 1 is a perspective view illustrating the front of an electronic device according to an embodiment. FIG. 2 is a perspective view illustrating the rear of the electronic device according to an embodiment.

Referring to FIGS. 1 and 2, the electronic device 100 according to an embodiment may include a housing 110 that includes a first face (or front face) 110A, a second face (or back face) 110B, and a side face 110C surrounding the space between the first face 110A and the second face 110B. According to an embodiment (not illustrated), the housing may also refer to a structure that forms some of the first face 110A, the second face 110B, and the side face 110C in FIG. 1. According to an embodiment, the first face 110A may be formed at least in part of a substantially transparent front plate 102 (e.g., a glass plate including various coating layers, or a polymer plate). The second face 110B may be formed of a substantially opaque back plate 111. The back plate 111 may be formed, for example, of coated or colored glass, ceramic, polymer, metal (e.g., aluminum, stainless steel (STS), or magnesium), or a combination of at least two of the above materials. The side face 110C may be coupled to the front plate 102 and the back plate 111, and may be formed by a side bezel structure (or "side member") 118 including metal and/or polymer. In some embodiments, the back plate 111 and the side bezel structure 118 may be integrally formed and include the same material (e.g., a metallic material such as, for example, aluminum).

In the illustrated embodiment, the front plate 102 may include two first regions 110D that are bent and extend seamlessly from the first face 110A toward the back plate 111 at both ends of a long edge of the front plate 102. In the illustrated embodiment (see FIG. 2), the back plate 111 may include two second regions 110E that are bent and extend seamlessly from the second face 110B toward the front plate 102 at both ends of a long edge. In some embodiments, the front plate 102 (or the back plate 111) may include only one of the first regions 110D (or the second regions 110E). According to an embodiment, some of the first regions 110D or the second regions 110E may not be included. In the above embodiments, when viewed from a side of the electronic device 100, the side bezel structure 118 may have a first thickness (or width) at a side not including the first regions 110D or the second regions 110E, and have a second thickness less than the first thickness at a side including the first regions 110D or the second regions 110E.

According to an embodiment, the electronic device 100 may include at least one or more of a display 101, audio modules 103, 107, and 114, sensor modules 104, 116, and 119, camera modules 105, 112, and 113, a key input device 117, a light emitting element 106, a pen input device 120, and connector holes 108 and 109. In some embodiments, the electronic device 100 may omit at least one (e.g., the key input device 117 or the light emitting device 106) of the components or may additionally include other components.

According to an embodiment, the display 101 may be exposed, for example, through a significant portion of the front plate 102. In some embodiments, at least a portion of the display 101 may be exposed through the first face 110A and the front plate 102 that includes the first regions 110D of the side face 110C. In some embodiments, the edge of the display 101 may be formed to be substantially the same as an adjacent outer shape of the front plate 102. According to an embodiment (not illustrated), in order to expand an exposed area of the display 101, an outer edge of the display 101 and an outer edge of the front plate 102 may be formed to have substantially the same interval between the outer edge of the display 101 and the outer edge of the front plate 102.

According to an embodiment (not illustrated), a recess or an opening may be formed in a portion of a screen display region of the display 101, and at least one or more of the audio module 114, the sensor module 104, the camera module 105, and the light emitting device 106 aligned with the recess or the opening may be included. According to an embodiment (not illustrated), at least one or more of the audio module 114, the sensor module 104, the camera module 105, a fingerprint sensor 116, and the light emitting element 106 may be included on a rear surface of the screen display region of the display 101. According to an embodiment (not illustrated), the display 101 may be coupled to or be arranged adjacent to a touch detection circuit, a pressure sensor that may measure the intensity (pressure) of a touch input, and/or a digitizer that detects a magnetic field type stylus pen. In some embodiments, at least a portion of the sensor modules 104 and 119, and/or at least a portion of the key input device 117 may be arranged in the first regions 110D and/or the second regions 110E.

According to an embodiment, the audio modules 103, 107, and 114 may include a microphone hole 103 and speaker holes 107 and 114. A microphone configured to acquire external sound may be arranged inside the microphone hole 103, and in some embodiments, a plurality of microphones may be arranged and detect the direction of sound. The speaker holes 107 and 114 may include an external speaker hole 107 and a receiver hole 114 for audio applications (e.g., audio calls). In some embodiments, the speaker holes 107 and 114 and the microphone hole 103 may be implemented as one hole, or a speaker may be included without the speaker holes 107 and 114 (e.g., a piezo speaker).

According to an embodiment, the sensor modules 104, 116, and 119 may generate an electrical signal or data value corresponding to an internal operating state of the electronic device 100 or the external environmental state. The sensor modules 104, 116, 119 may include, for example, a first sensor module 104 (e.g., proximity sensor) and/or a second sensor module (not illustrated) (e.g., fingerprint sensor) that are disposed on the first face 110A of the housing 110, and/or a third sensor module 119 (e.g., heart rate monitor (HRM) sensor) and/or a fourth sensor module 116 (e.g., fingerprint sensor) that are disposed on the second face 110B of the housing 110. The fingerprint sensor may be disposed on the first face 110A (e.g., the display 101) of the housing 110 and the second face 110B. The electronic device 100 may further include a sensor module not illustrated, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illumination sensor 104.

According to an embodiment, the camera modules 105, 112, and 113 may include a first camera device 105 disposed on the first face 110A of the electronic device 100, a second camera device 112 disposed on the second face 110B, and/or a flash 113. The first camera device 105 and second camera device 112 may each include one or more lenses, an image sensor, and/or an image signal processor. The flash 113 may include, for example, a light emitting diode or a xenon lamp. In some embodiments, two or more lenses (an infrared camera, a wide-angle lens, and a telephoto lens) and image sensors may be disposed on one face of the electronic device 100.

According to an embodiment, the key input device 117 may be disposed on the side face 110C of the housing 110. According to an embodiment, the electronic device 100 may omit part or all of the above-mentioned key input device 117, and the key input device 117 omitted may be implemented in a different form such as, for example, a soft key, etc. on the display 101. In some embodiments, the key input device 117 may be implemented as the sensor module 116 disposed on the second face 110B of the housing 110.

According to an embodiment, the light emitting device 106 may be disposed on, for example, the first face 110A of the housing 110. For example, the light emitting device 106 may provide status information of the electronic device 100 in the form of light. According to an embodiment, the light emitting device 106 may provide, for example, a light source interworking with the operation of the camera module 105. The light emitting device 106 may include, for example, an LED, an infrared (IR) LED, or a xenon lamp.

According to an embodiment, the connector holes 108 and 109 may include a first connector hole 108 that may accommodate a connector (for example, a USB connector) for transmitting and receiving power and/or data with an external electronic device, and/or a second connector hole 109 (e.g., an earphone jack) that may accommodate a connector for transmitting and receiving an audio signal with the external electronic device.

According to an embodiment, the pen input device 120 (e.g., a stylus pen) may be guided and inserted into, or attached to and detached from, the interior of the housing 110 through the hole 121 formed in the side face of the housing 110, and may include a button for facilitating attachment and detachment. The pen input device 120 may have a separate resonance circuit built therein and interwork with an electromagnetic induction panel 390 (e.g., a digitizer) included in the electronic device 100. The pen input device 120 may support inputs according to an electro-magnetic resonance (EMR) method, an active electrical stylus (AES) method, and an electric coupled resonance (ECR) method.

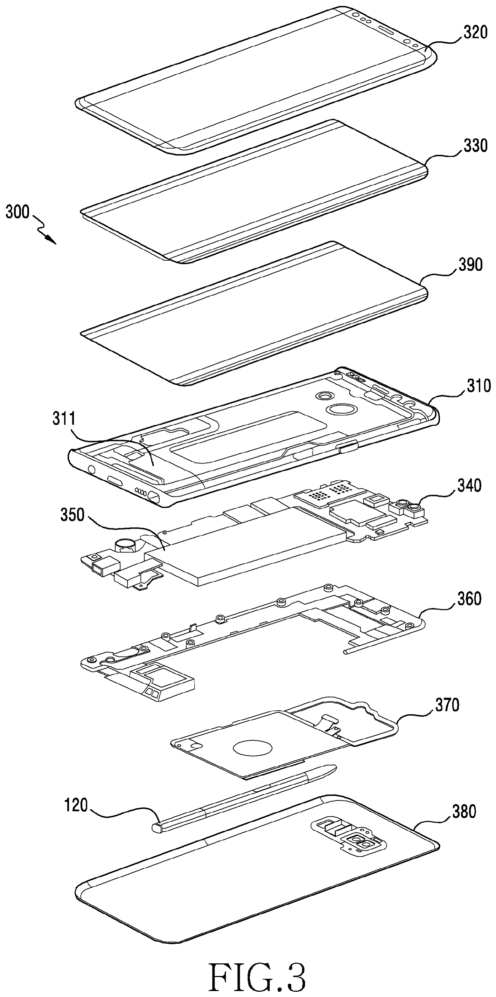

FIG. 3 is an exploded perspective view illustrating an internal construction of an electronic device according to an embodiment.

Referring to FIG. 3, the electronic device 300 may include a side bezel structure 310, a first support member 311 (e.g., a bracket), a front plate 320, a display 330, an electromagnetic induction panel 390, a printed circuit board 340, a battery 350, a second support member 360 (e.g., a rear case), an antenna 370, a pen input device 120, and a back plate 380. In some embodiments, the electronic device 300 may omit at least one (e.g., the first support member 311 or the second support member 360) of the components or may additionally include other components. At least one of the components of the electronic device 300 may be the same as or similar to at least one of the components of the electronic device 100 of FIG. 1 or FIG. 2, and repeated descriptions are omitted for brevity.

According to an embodiment, the electromagnetic induction panel 390 (e.g., digitizer) may include a panel for detecting an input from the pen input device 120. For example, the electromagnetic induction panel 390 may include a printed circuit board (PCB) (e.g., a flexible printed circuit board (FPCB)) and a shield sheet. The shield sheet may prevent or reduce interference between components caused by an electromagnetic field generated from the components (e.g., a display module, a printed circuit board, and an electromagnetic induction panel) included in the electronic device 100. The shield sheet blocks or reduces the electromagnetic field generated from the components, and the shield sheet supports accurate transfer of an input from the pen input device 120 to a coil included in the electromagnetic induction panel 240. The electromagnetic induction panel 240 according to various embodiments may include an opening formed in at least a partial region corresponding to a biometric sensor arranged in the electronic device 100.

According to an embodiment, the first support member 311 may be arranged inside the electronic device 300 and be connected to the side bezel structure 310, or the first support member 311 may be formed integrally with the side bezel structure 310. The first support member 311 may be formed of, for example, a metallic material and/or a non-metallic (e.g., polymer) material. The display 330 may be coupled to a surface of the first support member 311, and the printed circuit board 340 may be coupled to another surface of the first support member 311. A processor, a memory, and/or an interface may be installed in the printed circuit board 340. The processor may include, for example, one or more of a central processing unit, an application processor, a graphics processing unit, an image signal processor, a sensor hub processor, or a communication processor.

According to an embodiment, the memory may include, for example, a volatile memory or a nonvolatile memory.

According to an embodiment, the interface may include, for example, a high definition multimedia interface (HDMI), a universal serial bus (USB) interface, an SD card interface, and/or an audio interface. For example, the interface may electrically or physically connect the electronic device 300 to an external electronic device and may include a USB connector, an SD card / MMC connector, or an audio connector.

According to an embodiment, the battery 350 may include a device for supplying power to at least one component of the electronic device 300, and may include, for example, a non-rechargeable primary battery, a rechargeable secondary battery, or fuel battery. At least part of the battery 350 may be disposed, for example, on substantially the same plane as the printed circuit board 340. The battery 350 may be arranged integrally within the electronic device 300 or may be arranged to be detachable from the electronic device 300.

According to an embodiment, the antenna 370 may be arranged between the back plate 380 and the battery 350. The antenna 370 may include, for example, a near field communication (NFC) antenna, a wireless charging antenna, and/or a magnetic secure transmission (MST) antenna. For example, the antenna 370 may perform short-distance communication with an external device or wirelessly transmit and receive power required for charging. According to an embodiment, an antenna structure may be formed by part of the side bezel structure 310 and/or the first support member 311 or a combination thereof.

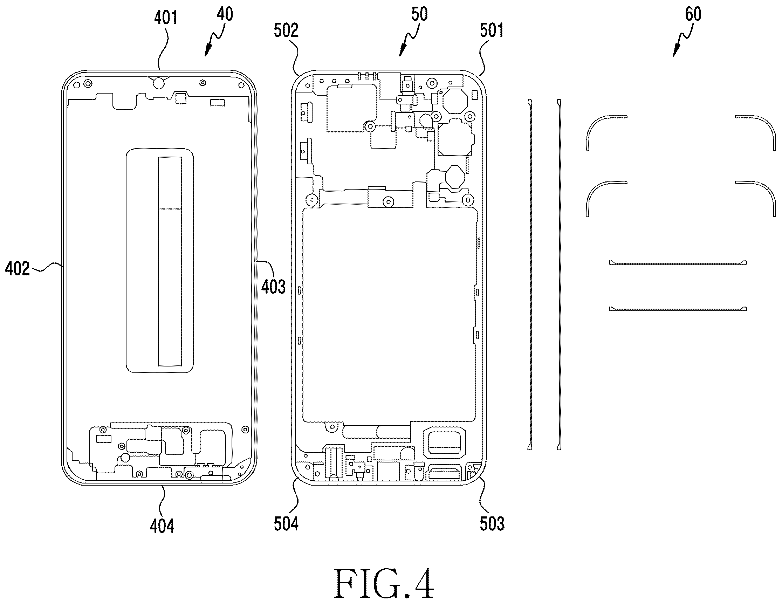

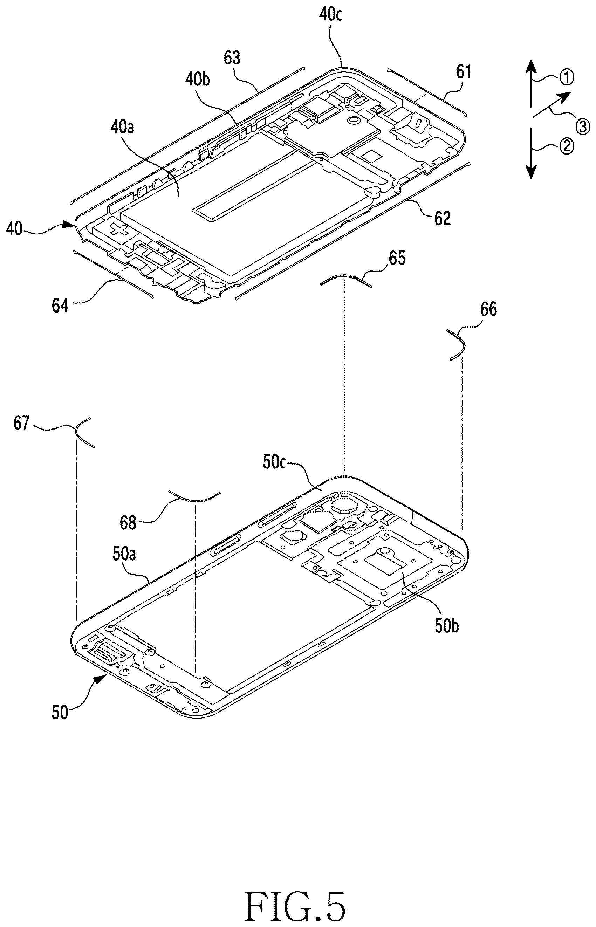

FIG. 4 is a plan view illustrating a front case, a rear case, and a waterproof structure that constitute an electronic device, according to an embodiment. FIG. 5 is a plan view illustrating the waterproof structure arranged in each of the front case and the rear case that constitute the electronic device, according to an embodiment.

The terms "waterproof structure" and "waterproofing structure" may be used interchangeably herein. For example, a "waterproof structure" described herein may support features described herein for waterproofing an electrical device (or a potential entry points of the electrical device) against the penetration of moisture, a liquid, or the like.

Referring to FIGS. 4 and 5, an electronic device (e.g., the electronic device 100 illustrated in FIG. 1) according to an embodiment may include a portable communication device. According to an embodiment, the electronic device may include a housing (e.g., the housing 110 illustrated in FIG. 1), and the housing may include a front plate (e.g., the front plate 102 illustrated in FIG. 1), a back plate (e.g., the back plate 111 illustrated in FIG. 2), a front case 40, a rear case 50, and a waterproof structure 60.

According to an embodiment, the front case 40 may be coupled to the rear case 50 by using a catch structure or fastener not illustrated. According to an embodiment, the waterproof structure 60 may be arranged between the front case 40 and the rear case 50 and prevent or reduce moisture penetration into the housing.

According to an embodiment, when viewed from above, the front case 40 may have a substantially rectangular shape, and may include a first straight edge 401 to a fourth straight edge 404. According to an embodiment, the front case 40 may include a first face 40a oriented in a first direction ① (e.g., a direction toward the front plate), a second face 40b (a face opposite the first face) oriented in a second direction ② (e.g., a direction toward the back plate) opposite the first direction ①, and a first side face 40c oriented in a third direction ③ (e.g., a lateral direction) that is substantially perpendicular to each of the first direction ① and the second direction ②.

According to an embodiment, the third direction ③ is not limited to a direction substantially perpendicular to the first direction ① and the second direction ②, and the third direction ③ may be a direction slightly inclined (e.g., 10 degrees or less) from the direction perpendicular to the first direction ① and the second direction ②.

For example, the first direction ① may include an up direction, the second direction ② may include a down direction, the third direction ③ may include a lateral direction, the first face 40a may include an upper surface, and the second face 40b may include a lower surface. According to an embodiment, the first side face 40c may include a straight section.

According to an embodiment, when viewed from above, the rear case 50 may have a substantially rectangular shape and may include a first corner region 501 to a fourth corner region 504. According to an embodiment, the rear case 50 may include a third face 50a oriented in the first direction, a fourth face 50b (a face opposite the third face) oriented in the second direction opposite the first direction, and a second side face 50c oriented perpendicular to the first direction and the second direction. For example, the first direction may include an up direction, the second direction may include a down direction, the third face 50a may include an upper surface, and the fourth face 50b may include a lower surface. According to an embodiment, the first corner region 501 to the fourth corner region 504 may each include a curve section.

According to an embodiment, the waterproof structure 60 may include first waterproof members 61 to 64 (also referred to herein as first sponge member 61 to fourth sponge member 64) disposed on the front case 40 and second waterproof members 65 to 68 (also referred to herein as fifth sponge member 65 to eighth sponge member 68) disposed on the rear case 50. According to an embodiment, the first waterproof members 61 to 64 may be disposed on the front case 40, and the second waterproof members 65 to 68 may be disposed on the rear case 50.

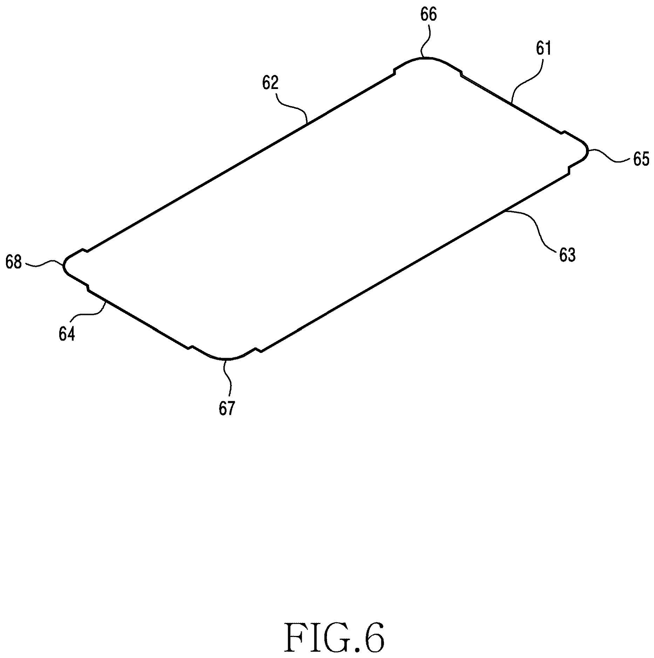

FIG. 5 is a plan view illustrating a waterproof structure arranged in each of a front case and a rear case that constitute an electronic device according to an embodiment. FIG. 6 is an example diagram illustrating the waterproof structure of the electronic device according to an embodiment.

Referring to FIGS. 5 and 6, according to an embodiment, in a state in which (i.e., when) the front case 40 is coupled to the rear case 50), at least some of the first waterproof members 61 to 64 may be connected to at least some of the second waterproof members 65 to 68. According to an embodiment, in the state in which (i.e., when) the front case 40 is coupled to the rear case 50, the first waterproof members 61 to 64 may be integrally connected to the second waterproof members 65 to 68. For example, in the state in which (i.e., when) the front case 40 is coupled to the rear case 50, when viewed from above the front case 40, the first waterproof members 61 to 64 may be integrally connected to the second waterproof members 65 to 68. In an example in which the front case 40 is coupled to the rear case 50, the first waterproof members and the second waterproof members may be arranged in a closed-curve shape.

According to an embodiment, the first waterproof members 61 to 64 may be disposed on a side face of the front case 40, and the second waterproof members 65 to 68 may be disposed on a side face of the rear case 50. According to an embodiment, the first waterproof members 61 may include a first sponge member 61 to a fourth sponge member 64 respectively disposed on a first straight edge to a fourth straight edge of the front case 40. According to an embodiment, the second sponge member 62 and the third sponge member 63 among the first sponge member 61 to the fourth sponge member 64 may be formed such that lengths of the second sponge member 62 and the third sponge member 63 are respectively greater than lengths of the first sponge member 61 and the fourth sponge member 64. According to an embodiment, the first sponge member 61 to the fourth sponge member 64 may each have a straight shape. According to an embodiment, the first waterproof members 61 to 64 may be attached to the front case 40. According to an embodiment, materials of the first waterproof members 61 to 64 are not limited to a sponge, and the materials may be replaced with a material of any one of a bonding layer or a silicon rubber. For example, the first waterproof members 61 to 64 may include a sponge, a bonding layer, a silicon rubber, or a combination thereof.

According to an embodiment, the second waterproof members 65 to 68 may include a fifth sponge member 65 to an eighth sponge member 68 respectively arranged in the first corner region 501 to the fourth corner region 504 of the rear case 50. According to an embodiment, the fifth sponge member 65 to the eighth sponge member 68 may be formed such that each of the fifth sponge member 65 to the eighth sponge member 68 is a curve shape. In some aspects, the fifth sponge member 65 to the eighth sponge member 68 may be formed as the same shape. According to an embodiment, the second waterproof members 65 to 68 may be attached to the rear case 50. According to an embodiment, materials of the second waterproof members 65 to 68 are not limited to a sponge, and the materials may be replaced with a material of any one of a bonding layer or a silicon rubber. For example, the second waterproof members 65 to 68 may include a sponge, a bonding layer, a silicon rubber, or a combination thereof.

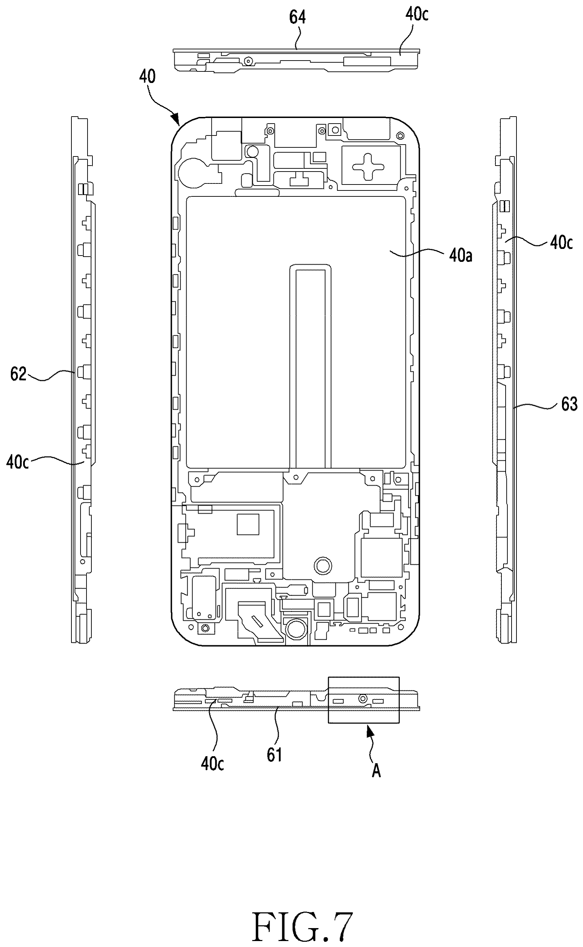

The installation of the first waterproof members according to an embodiment is described herein with reference to FIGS. 7 to 10.

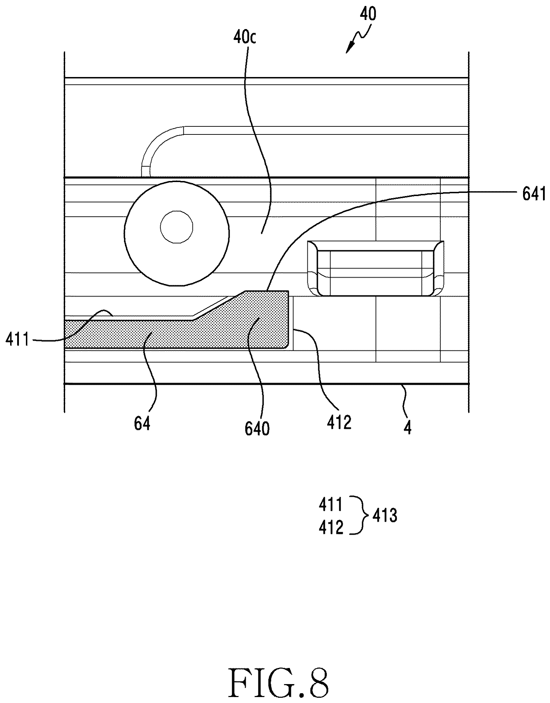

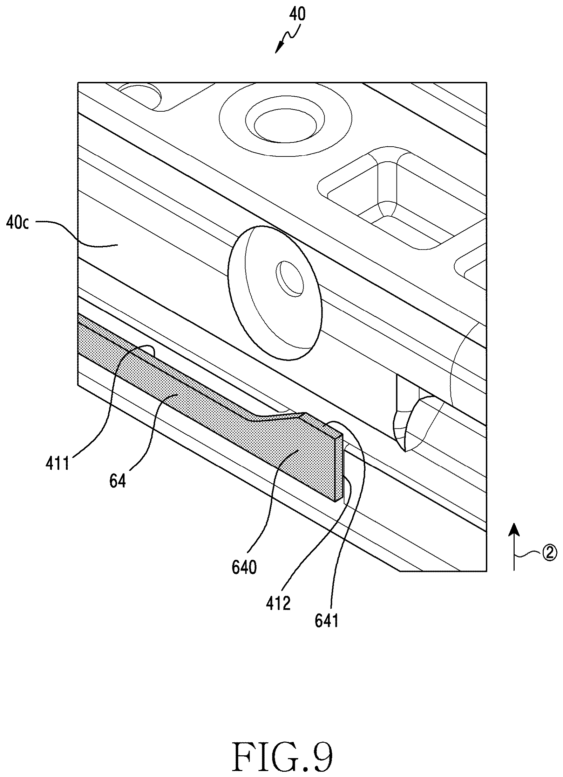

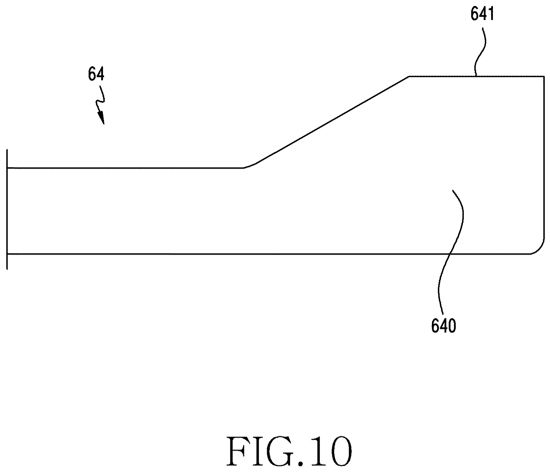

FIG. 7 illustrates a plan view and side views illustrating a front case according to an embodiment. FIG. 8 is an enlarged view illustrating region A of FIG. 7. FIG. 9 is a perspective view illustrating the region A of FIG. 7. FIG. 10 is a front view illustrating a protrusion portion of an end of a first waterproof member according to an embodiment.

Referring to FIGS. 7 to 10, according to an embodiment, the front case 40 may include four side faces 40c of flat straight shapes. According to an embodiment, the four side faces 40c may respectively extend along the first straight edge 401 to the fourth straight edge 404 of the case 40.

According to an embodiment, the front case 40 may have a first waterproof member (e.g., one of the first waterproof members 61 to 64) disposed on each side face 40c. For example, the first sponge member 61 and the fourth sponge member 64 may be disposed on the relatively short upper side face 40c and lower side face 40c, and the second sponge member 62 and the third sponge member 63 may be disposed on the relatively long left side face 40c and right side face 40c. According to an embodiment, each of the first sponge member 61 to the fourth sponge member 64 may each be a straight shape and may be attached to a respective side face 40c of the rear case 50 by a bonding layer. According to an embodiment, the first sponge member 61 and the fourth sponge member 64 may be arranged such that the first sponge member 61 and the fourth sponge member 64 face each other, and the second sponge member 62 and the third sponge member 63 may be arranged such that the second sponge member 62 and the third sponge member face each other. According to an embodiment, the first sponge member 61 and the fourth sponge member 64 may be arranged parallel to each other, and the second sponge member 62 and the third sponge member 63 may be arranged parallel to each other.

According to an embodiment, each of the first sponge member 61 to the fourth sponge member 64 may be arranged closer to the second face 40b (illustrated at FIG. 5) than to the first face 40a. This arrangement of the first waterproof members 61 to 64 effectively prevents or reduces moisture penetration at the entry point of moisture penetration in accordance with aspects of the present disclosure.

According to an embodiment, each of the first sponge member 61 to the fourth sponge member 64 constituting the first waterproof members 61 to 64 may have a straight shape and may include a protrusion portion at each end. For example, protrusion portions may be formed at both ends of the first sponge member 61, respectively, protrusion portions may be formed at both ends of the second sponge member 62, respectively, protrusion portions may be formed at both ends of the third sponge member 63, respectively, and protrusion portions may be formed at both ends of the fourth sponge member 64, respectively. Since the structures of the protrusion portions of the first waterproof members 61 to 64 are the same as each other, the fourth sponge member 64 is described as an example, and the description of the remaining waterproof members 61 to 63 is omitted.

According to an embodiment, the fourth sponge member 64 may be a substantially straight shape, and the protrusion portions 640 may be formed at both ends of the fourth sponge member 64. According to an embodiment, the protrusion portions 640 of the fourth sponge member 64 may have the same shape and may be arranged symmetrical to each other. According to an embodiment, the protrusion portions 640 attached to the front case 40 may be oriented in the second direction.

According to an embodiment, the fourth sponge member 64 has a cross-section of a rectangular shape, but is not limited thereto. For example, the fourth sponge member 64 may have a cross-section of any one of a square shape, a circular shape, and an oval shape.

According to an embodiment, the front case 40 may have a receiving recess 413 in which the fourth sponge member 64 is seated. According to an embodiment, the receiving recess 413 may be formed in each of the four side faces 40c of the rear case 50. Since the structures of the four receiving recesses 413 have shapes corresponding to the first sponge member 61 to fourth sponge member 64, only the structure of the receiving recess 413 in which the fourth sponge member 64 is seated is described herein. That is, aspects of the structure of the receiving recess 413 in which the fourth sponge member 64 is seated may similarly apply to the structures of the receiving recesses 413 in which the first sponge member 61 to the third sponge member 63 are seated.

According to an embodiment, the receiving recess 413 may have a shape corresponding to the fourth sponge member 64. The receiving recess 413 may be a recess which is recessed to a certain depth and in which the fourth sponge member 64 is received and then seated, and the receiving recess 413 may include a substantially straight-shape receiving recess 411 and a protrusion-shape receiving recess 412. According to an embodiment, in a state in which (i.e., when) the fourth sponge member 64 is seated in the receiving recess 413, an upper end 641 of the fourth sponge member 64 is not received in the protrusion-shape receiving recess 412, but may protrude from the protrusion-shape receiving recess 412. The upper end 641 of the fourth sponge member 64 may have a portion overlapping a second waterproof member (e.g., seventh sponge member 67, eighth sponge member 68) and include a compressed portion.

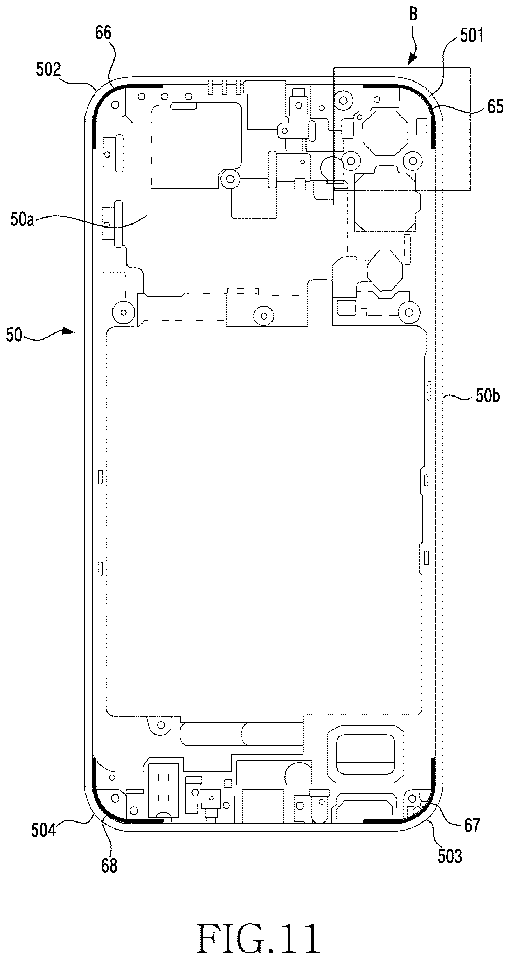

The installation of the second waterproof members 65 to 68 according to an embodiment is described herein with reference to FIGS. 11 to 13.

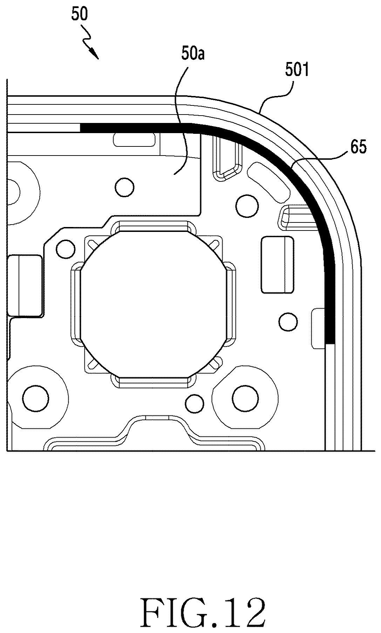

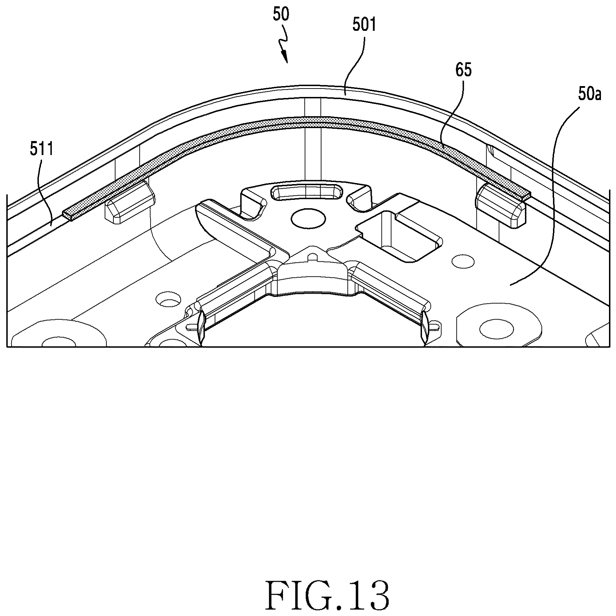

FIG. 11 is a plan view illustrating a rear case in which a second waterproof member is arranged, according to an embodiment. FIG. 12 is an enlarged view illustrating region B of FIG. 11. FIG. 13 is a perspective view illustrating the region B of FIG. 11.

Referring to FIGS. 11 and 12, the rear case 50 according to an embodiment may include the third face 50a oriented in the first direction, the fourth face 50b oriented in the second direction, and the side face 50c oriented in the third direction that is perpendicular to each of the first direction and the second direction. According to an embodiment, the rear case 50 may include the four first corner region 501 to fourth corner region 504. According to an embodiment, the fifth sponge member 65 to the eighth sponge member 68 may be arranged in the four corner regions 501 to 504, respectively. According to an embodiment, the fifth sponge member 65 to the eighth sponge member 68 may each have a curve shape and may be arranged along edges of the first corner region 501 to the fourth corner region 504, respectively.

According to an embodiment, the second waterproof members 65 to 68 may be disposed on the third face 50a of the rear case 50. For example, the fifth sponge member 65 to the eighth sponge member 68 may be arranged in a left-right symmetry, a top-bottom symmetry, or a top-bottom left-right symmetry, but are not limited to these symmetrical structures.

Referring to FIG. 13, the rear case 50 may have a step portion 511 formed along edges of corner regions (e.g., the first corner region 501 to the fourth corner region 504) of the third face 50a. In an example, the rear case 50 may include multiple step portions 511, in which the step portions 511 are spaced apart from one another and respectively formed along the edges of the corner regions of the third face 50a. In another example, the step portion 511 may be continuously formed along an edge of the rear case 50. According to an embodiment, the fifth sponge member 65 may be arranged in the step portion 511 formed in the corner region 501 of the third face of the rear case 50. For example, the fifth sponge member 65 may be attached to the step portion 511 by a bonding layer. According to an embodiment, each of the sixth sponge member 66 to the eighth sponge member 68 may have the same structure as the fifth sponge member 65 and be arranged in the step portion 511 as described with reference to the fifth sponge member 65.

According to an embodiment, the step portion 511 may be recessed from an upper edge of the corner region 501 of the rear case 50 to a predetermined depth.

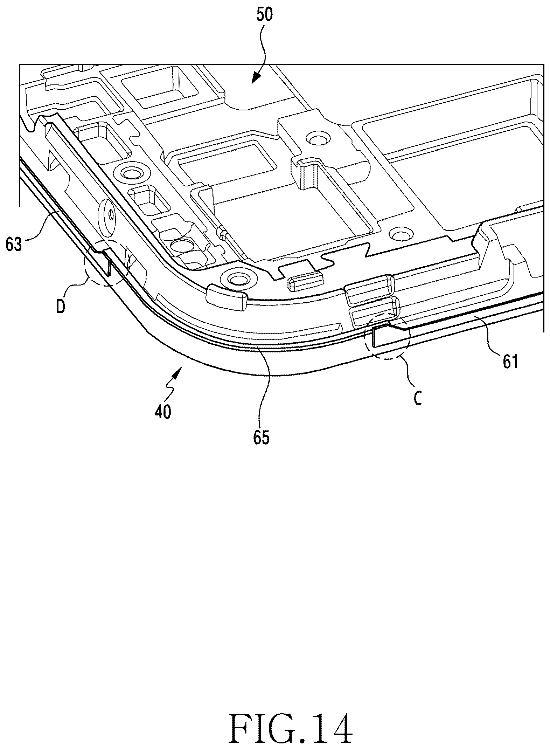

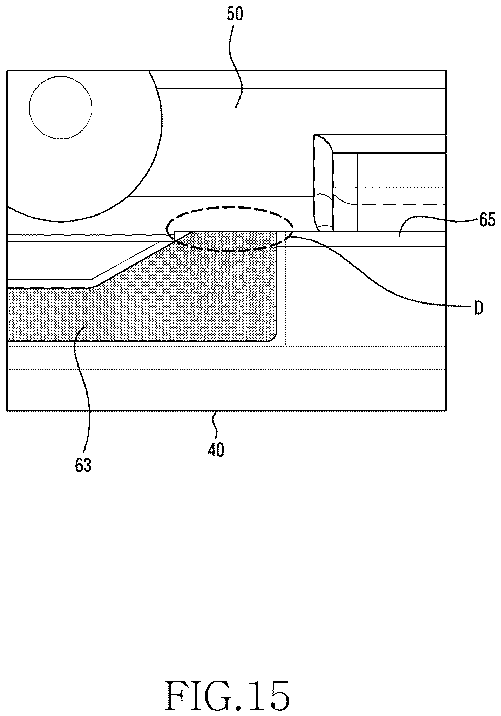

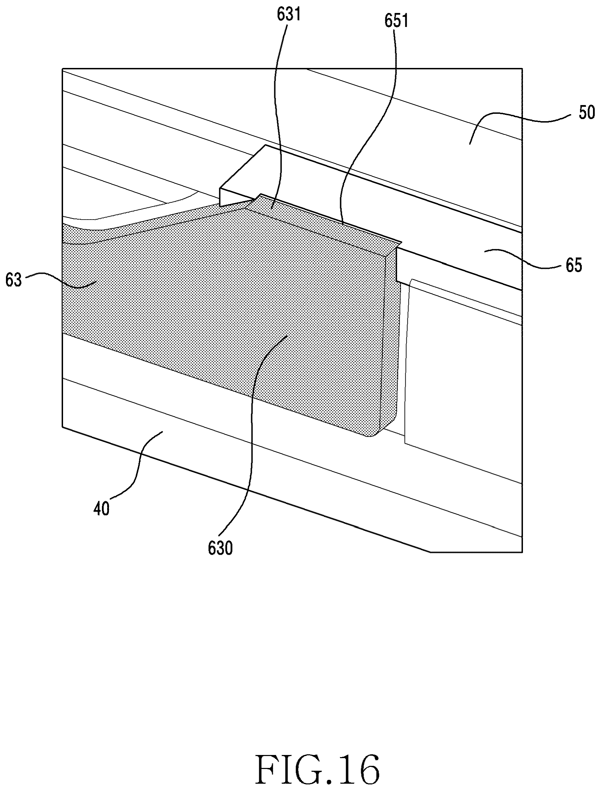

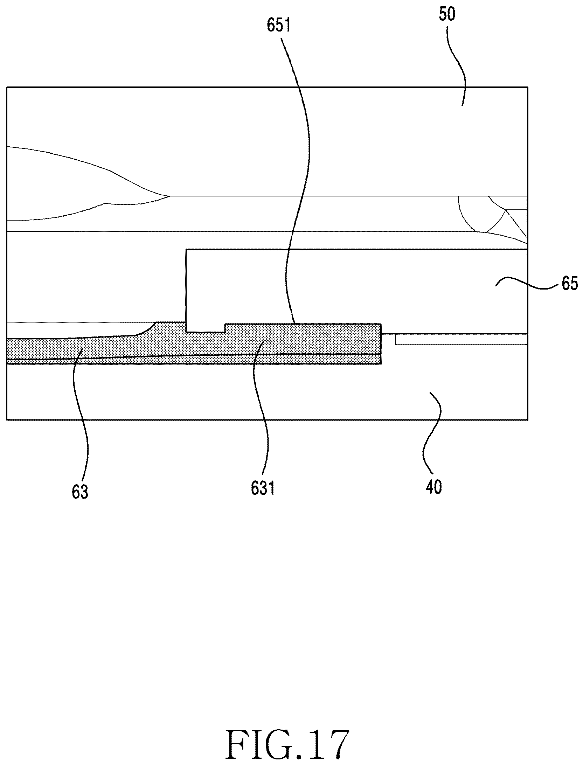

FIG. 14 is a perspective view illustrating a state in which a first waterproof member and a second waterproof member are overlapped and arranged, according to an embodiment. FIG. 15 is a front view illustrating the state in which the first waterproof member and the second waterproof member are overlapped and arranged, according to an embodiment. FIG. 16 is a perspective view illustrating the state in which the first waterproof member and the second waterproof member are overlapped and arranged, according to an embodiment. FIG. 17 is a plan view illustrating the state in which the first waterproof member and the second waterproof member are overlapped and arranged, according to an embodiment.

Referring to FIGS. 14 to 17, according to an embodiment, in a state in which (i.e., when) the front case 40 is coupled to the rear case 50, both end portions (ends) of each first waterproof member are connected to an end of a second waterproof member, and both end portions may be arranged in an overlapping (D) structure. According to an embodiment, in a boundary region between the first waterproof member and the second waterproof member, a part of the first waterproof member may be connected to a part of the second waterproof member and may be arranged such that the part of the first waterproof member overlaps the part of the second waterproof member.

For example, a protrusion portion of the third sponge member 63 disposed on a side face of the front case 40 may be arranged such that the protrusion portion of the third sponge member 63 overlaps (D) an end of the fifth sponge member 65 disposed on the third face of the rear case 50, and a protrusion portion of the first sponge member 61 may be arranged such that the protrusion portion of the first sponge member 61 overlaps (C) the other end of the fifth sponge member 65. According to an embodiment, a total of eight overlapping portions may be formed by the arrangement of the first waterproof members 61 to 64 and the second waterproof members 65 to 68. For example, each end of the fifth sponge member 65 to the eighth sponge member 68 that constitute the second waterproof members 65 to 68 may form an overlapping portion with an end of one of the first sponge member 61 to fourth sponge member 64. The overlapping portions may be located at boundary portions between the first waterproof members 61 to 64 and the second waterproof members 65 to 68.

Referring to FIGS. 16 and 17, in an example in which (i.e., when) the front case 40 is coupled to the rear case 50, an overlapping recess 651 for inserting an upper end 631 of the third sponge member may be formed in the fifth sponge member 65. According to an embodiment, the overlapping recess 651 may include a recess for inserting the upper end 631 of the third sponge member 63 protruding from a receiving recess and may have an overlapping structure between the third sponge member 63 (i.e., a first waterproof member) and the fifth sponge member 65 (i.e., a second waterproof member).

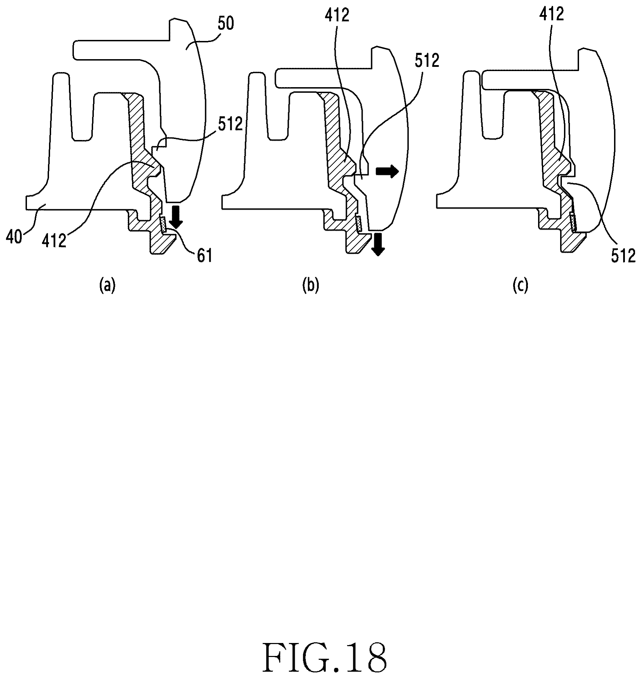

FIG. 18 is a cross-sectional view sequentially illustrating a process in which a rear case is coupled in a state where a first waterproof member is attached to a front case, according to an embodiment.

Referring to FIG. 18, according to an embodiment, in a process in which the front case 40 is coupled to the rear case 50, the first sponge member 61 attached to one side face of the front case 40 (e.g., the first sponge member 61 to the fourth sponge member 64 disposed on the front case 40) may be compressed by the rear case 50 at an end stage of the coupling process, by using catch structures 412 and 512 formed between the front case 40 and the rear case 50. Each of the catch structures 412 and 512 may be configured to perform a catching operation as described herein, for example, in which each of the catch structures 412 and 512 fix a component to another component.

According to an embodiment, a catch structure is provided which may include a first catch structure 412 (also referred to herein as a first catch portion 412) formed on the front case 40 and a second catch structure 512 (also referred to herein as a second catch portion 512) formed on the rear case 50, and the first sponge member 61 may be compressed at an end stage (or alternatively, at a relatively later stage) rather than at an early stage of the coupling process by sliding interworking between the first catch structure 412 and the second catch structure 512, thereby preventing or reducing a push of an attached state of the first sponge member 61 by the rear case 50.

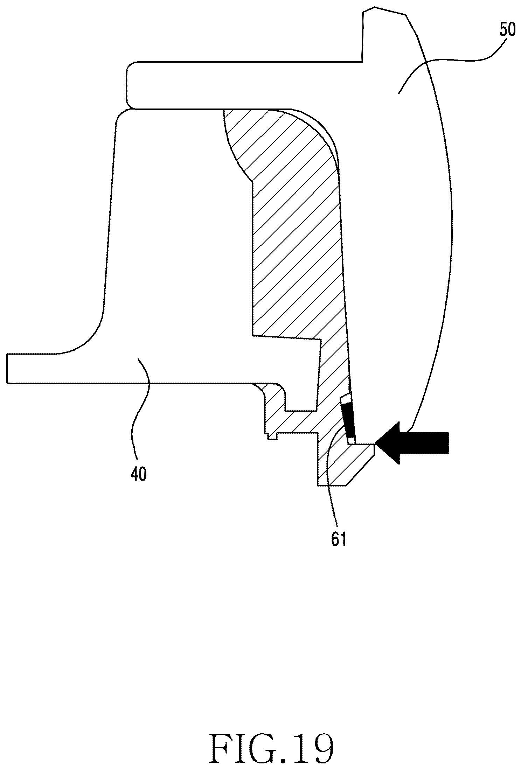

FIG. 19 is a cross-sectional view illustrating a waterproof structure in a straight section, according to an embodiment.

Referring to FIG. 19, according to an embodiment, the first waterproof member 61 is arranged in a straight section of a side face of the front case 40. The first waterproof member 61 may be located or positioned at a beginning of a coupling structure of the front case 40 and the rear case 50. In some cases, moisture may penetrate through a parting line between the front case 40 and the rear case 50 (i.e., penetrate in the direction of a thick arrow). According to an embodiment, the first waterproof member 61 may be arranged at an entrance adjacent (or close) to the parting line and thus may have a structure advantageous for efficiently and effectively preventing or reducing moisture penetration. The term "close" used herein may refer to a distance less than or equal to a threshold distance. An element described as close to another element may be within a threshold distance of the other element.

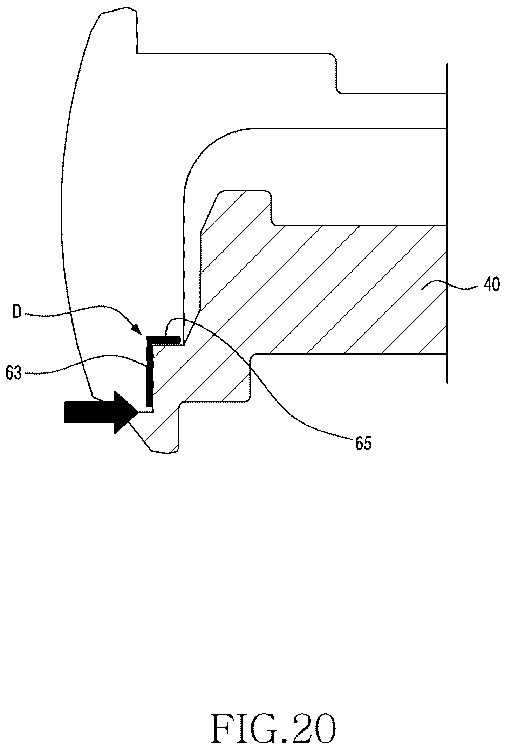

FIG. 20 is a cross-sectional view illustrating a waterproofing structure in an overlapping section, according to an embodiment.

Referring to FIG. 20, according to an embodiment, in a section where the first waterproof member 63 is connected to the second waterproof member 65, that is, in a corner region of the rear case 50 where a straight section meets with a curve section, the first waterproof member 63 and the second waterproof member 65 may be located at a beginning (e.g., entrance, potential entry point of moisture, an intersection point between included components, a start point of a parting line described herein) of a coupling structure of the front case 40 and the rear case 50. In some cases, moisture may penetrate through a parting line between the front case 40 and the rear case 50 (i.e., penetrate in the direction of a thick arrow) for cases in which the first waterproof member 63 and the second waterproof member 65 described herein are not implemented. According to an embodiment, the first waterproof member 63, the second waterproof member 65, and an overlapping portion between the first waterproof member 63 and the second waterproof member 65 may be arranged at the entrance adjacent (or close) to the parting line and thus may have a structure advantageous for efficiently and effectively preventing or reducing moisture penetration.

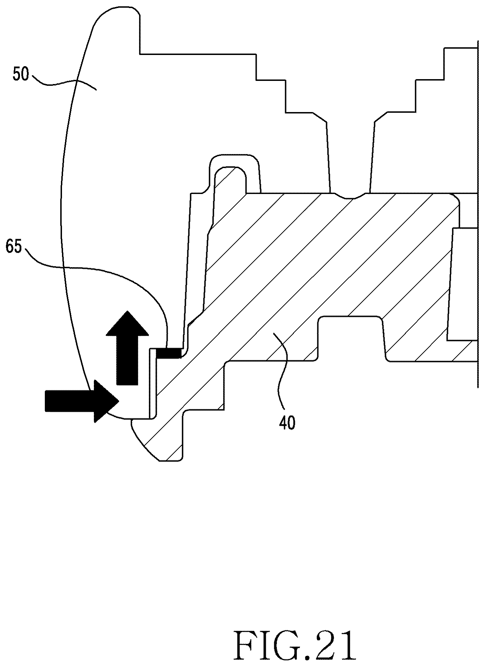

FIG. 21 is a cross-sectional view illustrating a waterproof structure in a curve section, according to an embodiment.

Referring to FIG. 21, according to an embodiment, the second waterproof members 65 to 68 are arranged in the curve section that is a corner region of the third face 50a of the rear case 50. The second waterproof members 65 to 68 may be located adjacent (or close) to a beginning of a coupling structure of the front case 40 and the rear case 50. In some cases, moisture may penetrate through a parting line between the front case 40 and the rear case 50 (i.e., penetrate in the direction of the thick arrows). According to an embodiment, the second waterproof member (e.g., the fifth sponge member 65) may be arranged at an entrance adjacent (or close) to the parting line and thus may have a structure advantageous for efficiently and effectively preventing or reducing moisture penetration.

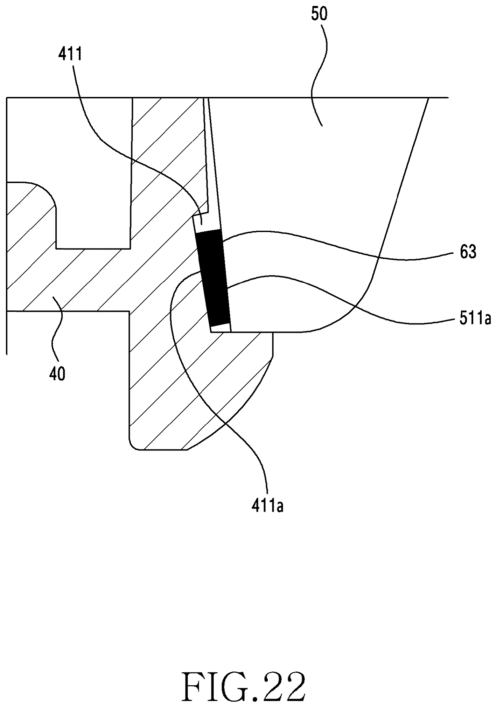

FIG. 22 is a cross-sectional view illustrating an arrangement state of a first waterproof member (e.g., the third sponge member 63), according to an embodiment.

Referring to FIG. 22, according to an embodiment, a face 411a, to which the straight first waterproof member 63 is attached, of the receiving recess 411 formed in the front case 40 may be arranged substantially parallel to a face 511a of the rear case 50 facing the attached first waterproof member 61. According to an embodiment, the face 411a to which the first waterproof member 61 is attached may be formed as a flat surface, and the face 511a of the rear case 50 facing the first waterproof member 61 may be formed as a flat surface. According to an embodiment, in an example in which (i.e., when) the front case 40 is coupled to the rear case 50, the attached first waterproof member 63 may be compressed and may remain compressed.

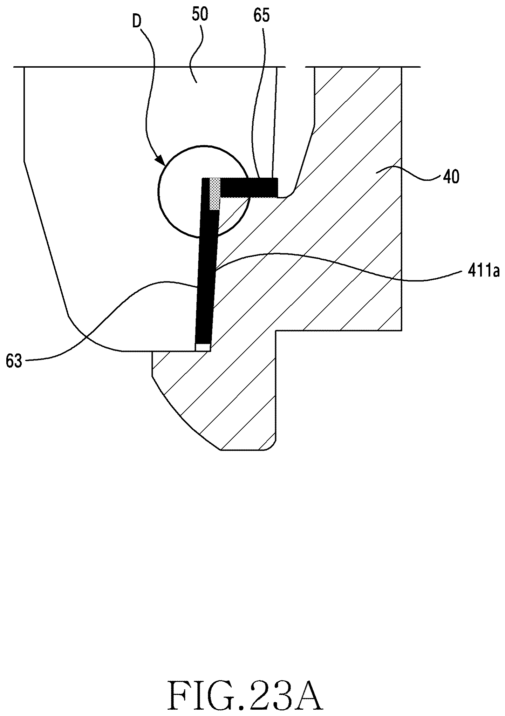

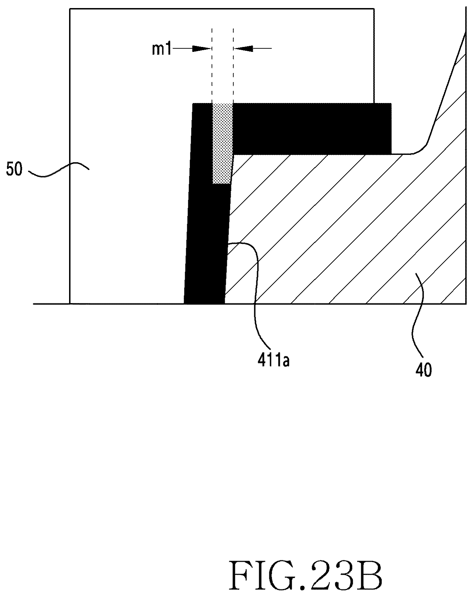

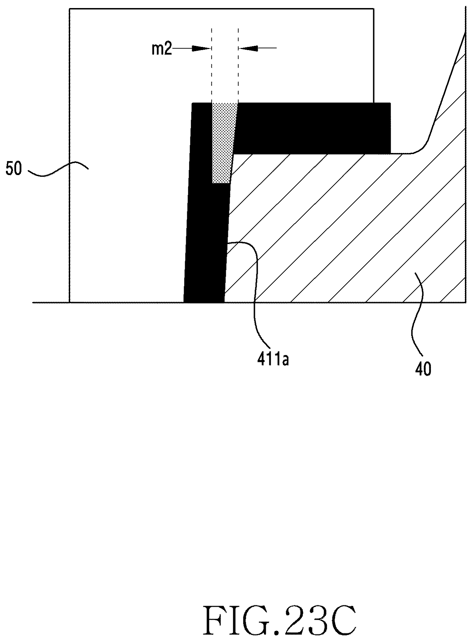

FIG. 23A is a cross-sectional view illustrating a waterproof structure in an overlapping section, according to an embodiment, FIG. 23B illustrates the amount of overlap when an attachment surface of a front case is inclined 3 degrees (or about 3 degrees) from the direction perpendicular to the first direction, and FIG. 23C is an example diagram illustrating the amount of overlap when the attachment surface of the front case is inclined 5 degrees (or about 5 degrees) from the direction perpendicular to the first direction.

Referring to FIGS. 23A to 23C, according to an embodiment, in a section where the first waterproof member (e.g., third sponge member 63) overlaps the second waterproof member (e.g., fifth sponge member 65), the amount of overlap (E) between the first waterproof member and the second waterproof member may be different based on the degree of inclination of one face 411a of the front case 40 to which the first waterproof member (e.g., the third sponge member 63) is attached.

According to an embodiment, a face 411a of the front case 40 to which the first waterproof member (e.g., third sponge member 63) is attached may include a flat surface, and may be formed as a vertical wall (no slope) or may be formed in a slightly inclined state, for example, in an inclined state of 0 degrees to 5 degrees from the direction perpendicular to the first direction.

FIG. 23B illustrates a case where an inclination angle of a face 411a of the front case 40 to which the first waterproof member 63 is attached is 3 degrees, and FIG. 23C illustrates a case where the inclination angle of the face 411a of the front case 40 to which the first waterproof member 61 is attached is 5 degrees. According to an embodiment, the amount of overlap m2 for a case in which the inclination angle of the face 411a of the front case 40 to which the first waterproof member 63 is attached is 5 degrees may be greater than the amount of overlap m1 for a case in which the inclination angle of the one face of the front case 40 to which the first waterproof member 63 is attached is 3 degrees.

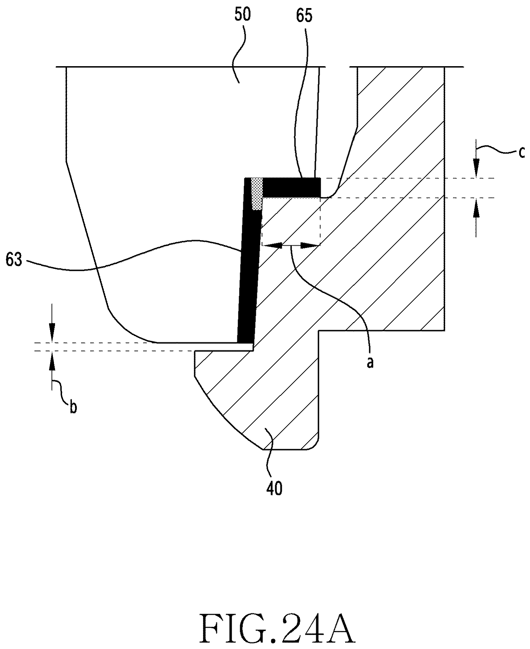

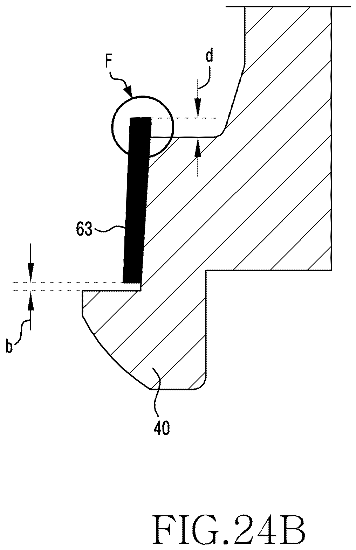

FIG. 24A is a cross-sectional view illustrating a waterproofing structure in an overlapping section according to an embodiment, and FIG. 24 is a diagram illustrating a protrusion portion of a first waterproof member overlapping.

Referring to FIG. 24A, according to an embodiment, in a section where a first waterproof member (e.g., the third sponge member 63) overlaps a second waterproof member (e.g., the fifth sponge member 65), as an area (a) of a contact surface between the second waterproof member 65 and the front case 40 and a contact surface between the second waterproof member 65 and the rear case 50 increases, the size of the area providing waterproofing as described herein may increase and this may be advantageous for waterproofing.

According to an embodiment, a gap (b) may exist between an end of the first waterproof member 63 and a face of a step portion of the front case 40. According to an embodiment, the gap (b) may be formed in consideration of a manufacturing tolerance of the rear case 50 or the front case 40 and prevent the first waterproof member 61 from being exposed to the outside.

According to an embodiment, a gap (c) between the front case 40 and the rear case 50, where the second waterproof member 65 is arranged, may be designed such that a compression rate of the second waterproof member 65 may range from 30% to 50%.

Referring to FIG. 24B, according to an embodiment, the first waterproof member 63 may be arranged to protrude a certain length (d) from a face of the rear case 50. According to an embodiment, the first waterproof member 63 may be arranged to protrude in consideration of the amount of overlap with the second waterproof member. According to an embodiment, the protrusion length (d) may include an overlapping portion.

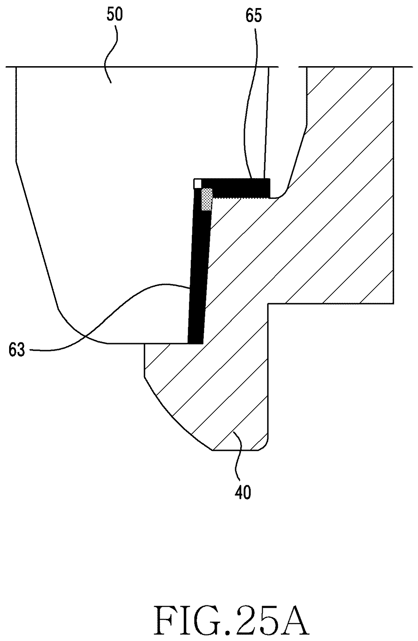

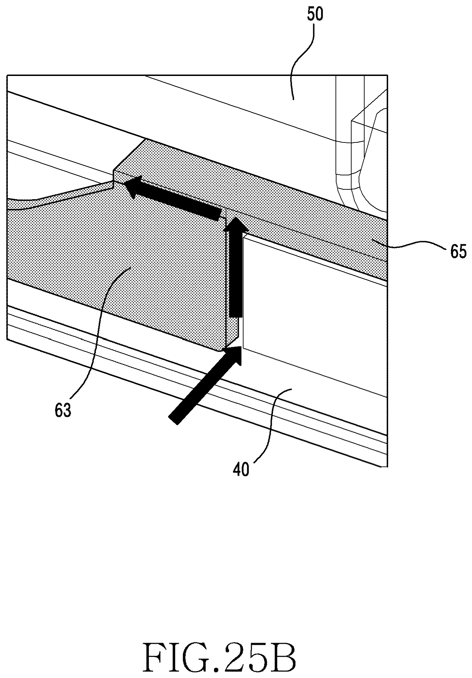

FIG. 25A is a cross-sectional view of a case illustrating a state in which the amount of overlap between a first waterproof member (e.g., third sponge member 63) and a second waterproof member (e.g., fifth sponge member 65) is insufficient, and FIG. 25B is a perspective view illustrating a path of moisture penetration with arrows.

Referring to FIGS. 25A and 25B, in an overlapping section between the first waterproof member (e.g., third sponge member 63) and the second waterproof member (e.g., fifth sponge member 65), if a protrusion length of the first waterproof member 61 is short (e.g., less than a threshold length), the amount of overlap (D) between the first waterproof member 63 and the second waterproof member 65 may be insufficient for preventing moisture penetration as described herein, and thus, moisture may be able to penetrate in the direction of arrows (a penetration path along which moisture advances) through a parting line between the front case 40 and the rear case 50. In other words, the insufficient amount of overlap (D) between the first waterproof member and the second waterproof member may deteriorate a waterproofing function of the first waterproof member and the second waterproof member.

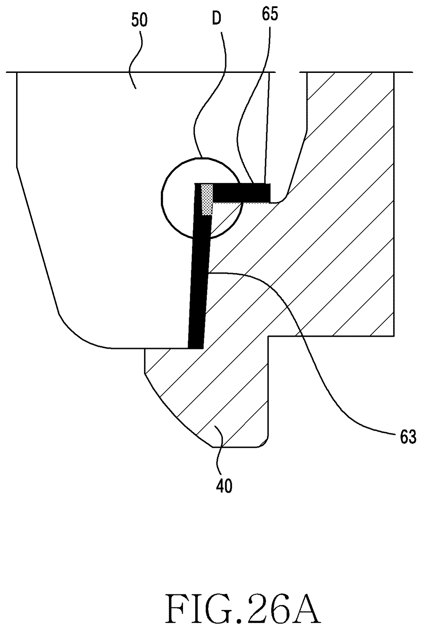

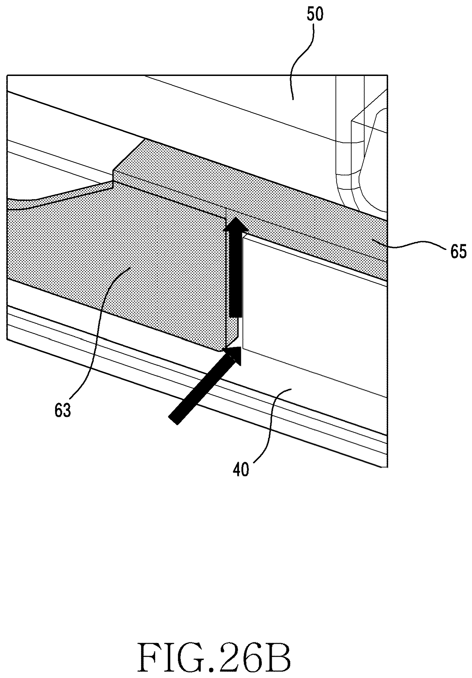

FIG. 26A is a cross-sectional view illustrating a state in which the amount of overlap between a first waterproof member (e.g., third sponge member 63) and a second waterproof member (e.g., fifth sponge member 65) according to an embodiment is appropriate for preventing moisture penetration as described herein, and FIG. 26B is a perspective view illustrating a path of moisture penetration with arrows.

Referring to FIGS. 26A and 26B, according to an embodiment, in an overlapping section between the first waterproof member 63 and the second waterproof member 65, when a protrusion length of the first waterproof member 61 is appropriate (e.g., satisfies a threshold protrusion length for preventing moisture penetration as described herein), the amount of overlap (D) between the first waterproof member 63 and the second waterproof member 65 is appropriate (e.g., satisfies a threshold amount of overlap for preventing moisture penetration as described herein), and thus, it is possible to prevent or reduce moisture penetration through a parting line between the front case 40 and the rear case 50. The direction of arrows indicates a path of moisture penetration, and penetrated moisture cannot advance further in an overlapping (D) portion between the first waterproof member 63 and the second waterproof member 65, whereby the moisture penetration may be prevented or reduced.

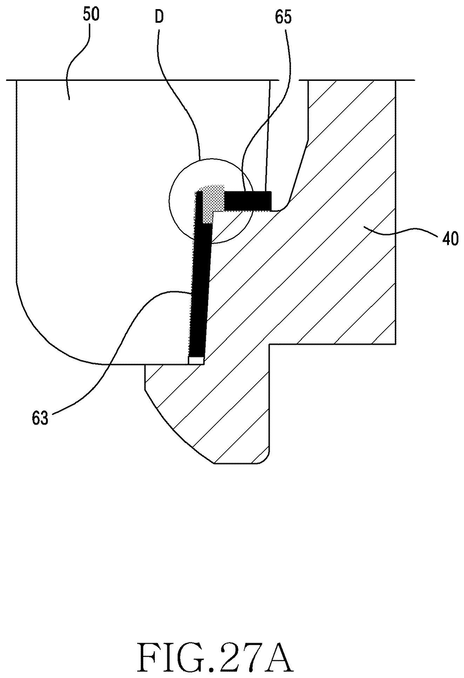

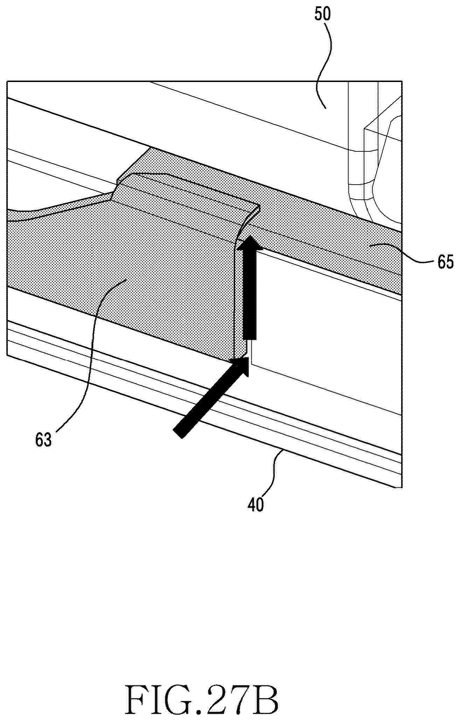

FIG. 27A is a cross-sectional view illustrating a state in which the amount of overlap between a first waterproof member (e.g., third sponge member 63) and a second waterproof member (e.g., fifth sponge member 65) according to an embodiment is excessive, , and FIG. 27B is a perspective view illustrating a path of moisture penetration with arrows.

Referring to FIGS. 27A and 27B, in an overlapping section between the first waterproof member 63 and the second waterproof member 65, when a protrusion length of the first waterproof member 61 is excessive (e.g., exceeds a threshold protrusion length for preventing moisture penetration as described herein), the amount of overlap (D) between the first waterproof member 63 and the second waterproof member 65 is excessive (e.g., exceeds a threshold amount of overlap for preventing moisture penetration as described herein). Embodiments of the present disclosure support compressing the overlapping portion to a greater extent, thereby preventing or reducing moisture penetration through a parting line between the front case 40 and the rear case 50. The direction of the arrows indicates a path of moisture penetration, and penetrated moisture cannot advance further in the overlapping (D) portion between the first waterproof member 63 and the second waterproof member 65, and the moisture penetration may be prevented or reduced.

## Claims

1. An electronic device comprising:
a front plate;
a back plate;
a front case comprising:
a first face facing the front plate;
a second face facing the back plate; and
a first side face oriented in a lateral direction,
wherein the front case is arranged between the front plate and the back plate;
a rear case comprising:
a third face facing the front plate;
a fourth face facing the back plate; and
a second side face oriented in the lateral direction,
wherein the rear case is arranged between the front case and the back plate and is coupled to the front case; and
a waterproof structure comprising:
a first waterproof member disposed on the front case; and
a second waterproof member disposed on the rear case,
wherein a portion of the first waterproof member is connected to a portion of the second waterproof member, and a boundary portion where the first waterproof member is connected to the second waterproof member comprises an overlapping portion.

2. The electronic device of claim 1, wherein, in a state in which the front case is coupled to the rear case, the first waterproof member and the second waterproof member are integrally arranged in a closed-curve shape.

3. The electronic device of claim 1, wherein the first waterproof member is arranged in a straight shape along the first side face, and the second waterproof member is disposed on the third face.

4. The electronic device of claim 3, wherein the first waterproof member is disposed on the first side face along a straight section of the first side face, and the second waterproof member is arranged in a corner region of the third face along a curve section.

5. The electronic device of claim 3, wherein the first waterproof member is of a straight shape, and the second waterproof member is of a curve shape.

6. The electronic device of claim 3, wherein the first waterproof member comprises a first sponge member to a fourth sponge member that are each arranged along a respective straight section of the first side face.

7. The electronic device of claim 6, wherein the second waterproof member comprises a fifth sponge member to an eighth sponge member that are arranged at edges of corner regions of the third face.

8. The electronic device of claim 1, wherein the first waterproof member further comprises a protrusion portion that is arranged such that the protrusion portion overlaps the second waterproof member, and
the protrusion portion protrudes to the back plate.

9. The electronic device of claim 1, wherein the lateral direction is substantially perpendicular to each of directions in which the first face and the second face are oriented or is oriented in a direction substantially inclined from a direction perpendicular to the direction in which the first face is oriented and the direction in which the second face is oriented, and
the inclined direction has an inclination of 10 degrees or less.

10. The electronic device of claim 1, wherein the second waterproof member further comprises an overlapping recess for overlapping the first waterproof member.

11. The electronic device of claim 1, wherein:
the first side face further comprises a receiving recess in which the first waterproof member is seated, and
the receiving recess comprises:
a straight-shape receiving recess; and
a protrusion-shape receiving recess extending from the straight-shape receiving recess.

12. The electronic device of claim 1, wherein the first waterproof member is arranged within a threshold distance of the second face and stops, at a beginning, moisture penetration through a parting line provided by a coupling of the front case and the rear case.

13. The electronic device of claim 1, wherein the second waterproof member is arranged in a step portion that is recessed from the third face to the back plate.

14. The electronic device of claim 1, further comprising a catch structure formed between the front case and the rear case,
wherein, in a process of coupling the front case to the rear case, the first waterproof member is compressed by the rear case at an end of a catching operation of the catch structure.

15. An electronic device comprising:
a front case comprising:
a first face;
a second face opposite the first face; and
a first side face surrounding at least a portion of the front case between the first face and the second face;
a rear case comprising:
a third face facing the second face;
a fourth face opposite the third face; and
a second side face surrounding at least a portion of the rear case between the third face and the fourth face,
wherein the rear case is coupled to the front case; and
a waterproof structure comprising:
a first waterproof member disposed on the first side face; and
a second waterproof member disposed on the third face,
wherein a portion of the first waterproof member is connected to a portion of the second waterproof member, and a boundary portion where the first waterproof member is connected to the second waterproof member comprises an overlapping portion.
